# EUROPEAN PATENT SPECIFICATION

(11) **EP 0 414 352 B1**
(45) Date of publication and mention of the grant of the patent: **03.01.1996**
(21) Application number: 90306798.1
(22) Date of filing: 21.06.1990
(51) Int. Cl.: H04B 7/005

(54) **Radio transmitter with output power control**
Funksender mit Ausgangsleistungssteuerung
Emetteur radio à commande de puissance de sortie

(30) Priority: 26.06.1989 GB 8914637
(43) Date of publication of application: 27.02.1991
(73) Proprietor: ORBITEL MOBILE COMMUNICATIONS LIMITED (Reg. no. 2515004), Newbury, Berkshire RG14 1JX (GB)
(72) Inventor: Watson, Caroline Jane, Newbury, Berkshire RG14 7BT (GB); Bristow, Robert Owen, Eastrop, Basingstoke, Hampshire RG21 4MP (GB)
(74) Representative: Foster, David Martyn

(56) References cited:
- EP-A- 0 369 135
- US-A- 4 754 231
- PATENT ABSTRACTS OF JAPAN, vol. 8, no. 261 (E-281)[1698], 30th November 1984; & JP-A-59 132 267 (NIPPON DENKI K.K.) 30-07-1984
- 1988 IEEE INTERNATIONAL SYMPOSIUM ON CIRCUITS AND SYSTEMS, PROCEEDINGS, Espoo,
- 7th - 9th June 1988, vol. 2, pages 1803-1810, IEEE, New York, US; E. KUISMA et al.: "Signal processing requirements in Pan-European digital mobile communications"

## Description

The invention relates to a transmitter for a radio telephone system, comprising a power amplifier, detecting means coupled to the output of the power amplifier for detecting the output power of the amplifier and producing an output power signal dependent thereon, a voltage comparator having a first input coupled to receive the output power signal and a second input connected to receive a desired power signal dependent on the desired output power level for the power amplifier, the voltage comparator being operative to produce an output control signal which is connected to control the output power level of the power amplifier to the desired level, and control means for producing the desired power level signal, the control means comprising memory means having storage locations storing digital signals corresponding to different predetermined power levels, a control unit operative in dependence on the desired one of the predetermined power levels to cause the corresponding stored digital signals to be read out of the memory means, and digital to analogue converting means responsive to the read-out digital signals to produce the said desired power level signal.

Such a transmitter is known from US-A-4 754 231. In this known transmitter, however, the stored digital signals are stored as respective numbers of digits which are used in conjunction with a clocked counter to produce a square wave output, the duty cycle of the square wave output being dependent on the respective numbers of stored digits. This square wave is then passed through an integrating circuit to produce the control signal. This method of producing the control signal is not suitable for digital radio telephone systems such as the GSM system which require a control signal in the form of a pulse. A controlled pulse could not be produced by this known transmitter without increasing the frequency of the clocking rate to such a high value that it would be likely to interfere with the operation of the transmitter. The invention aims to overcome this problem.

The form of transmitter as first set forth above is also known, in the sense only of Article 54(3) and (4) EPC, from EP-A-0 369 135.

An article "Signal Processing Requirements in Pan-European Digital Mobile Communications" (1988 IEEE International Symposium on Circuits and Systems, Proceedings, Espoo, 7th-9th June 1988, vol 2, pages 1803-1810, IEEE, New York, US, Kuisna et al) describes features of the GSM system including the transmitter amplifier. It states that the rise and decay times of the pulsed signal for controlling the amplifier have to be very accurately controlled to reduce the spreading of the transmitted spectrum due to the pulsed switching of the amplifier. However, no means is disclosed for achieving this in a manner which will avoid undesirable phase shifts in the control loop. The invention also aims to overcome this problem.

According to the invention, therefore, the known form of transmitter as first set forth above is characterised by a phase adjustment circuit coupled to the voltage comparator and incorporating a negative feedback path for reducing undesirable phase shifts within the control loop, in that the desired power level signal is in the form of a desired power level signal pulse for causing the amplifier to produce a corresponding pulse of output power, and in that the memory means stores in each storage location digital data representing the value of a pulse corresponding to a respective one of the predetermined power levels, the read-out digital data being fed directly to the digital to analogue converter, initial and final portions of the digital data read-out being modified to cause the leading and trailing edges of the desired power level signal pulse to respectively increase and decrease progressively in a predetermined manner to reduce or eliminate RF sidebands created by the power amplifier.

The digital data is fed directly to the digital to analogue converter and in this way the leading and trailing edges of the desired power level signal pulse can be controlled to a predetermined shape.

The phase adjustment circuit on the voltage comparator operates to reduce undesirable phase shifts within the control loop. The phase adjustment circuit thus ensures stability of the control loop without reducing the response speed.

A transmitter embodying the invention and for use in a GSM radio telephone system will now be described, by way of example only, with reference to the accompanying diagrammatic drawings in which:
Figure 1 is a schematic view of the TDMA frame system of the GSM system;
Figure 2 is a schematic circuit diagram of the control system for a power amplifier incorporated in the transmitter;
Figure 3 is a schematic circuit diagram of part of the power amplifier, and Figure 3A shows the associated control characteristics;
Figure 4 is a schematic circuit diagram of phase control circuitry for connecting to the power amplifier in the transmitter; and
Figure 5 illustrates the form of the envelope of power level signals used in the transmitter.

The GSM Pan-European mobile telephone system is described, for example, in an article "Pan-European Cellular Radio" by D.M. Balston, "Electronics and Communication Engineering" Journal, Jan/Feb 1989, vol 1, no. 1, pp 7 to 13.

In the GSM system, data to be transmitted is modulated onto a 900 Mhz carrier by a Gaussian minimum shift keying technique (GMSK). Frequency channels are providing at a spacing of 200 kHz and data is transmitted in each channel at a total rate of 270.833 kbits⁻¹.

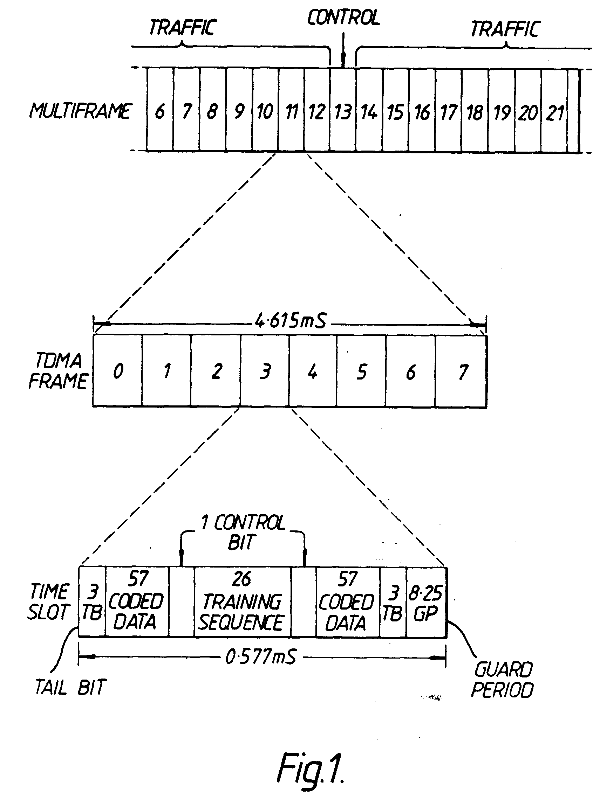

Figure 1 shows the basic format of one frequency channel for GSM transmissions as comprising a series of frames (Time Domain Multiple Axis Frames), each frame comprising eight multiplexed time slots from different mobile stations. Each frame is 4.615 ms in length and each time slot is 0.577 ms in length. The structure of a time slot as shown comprises two sections of data separated by control bits, tail bits etc. Data is transmitted from each mobile station within a time slot in compressed format at a rate of 13 kbits⁻¹.

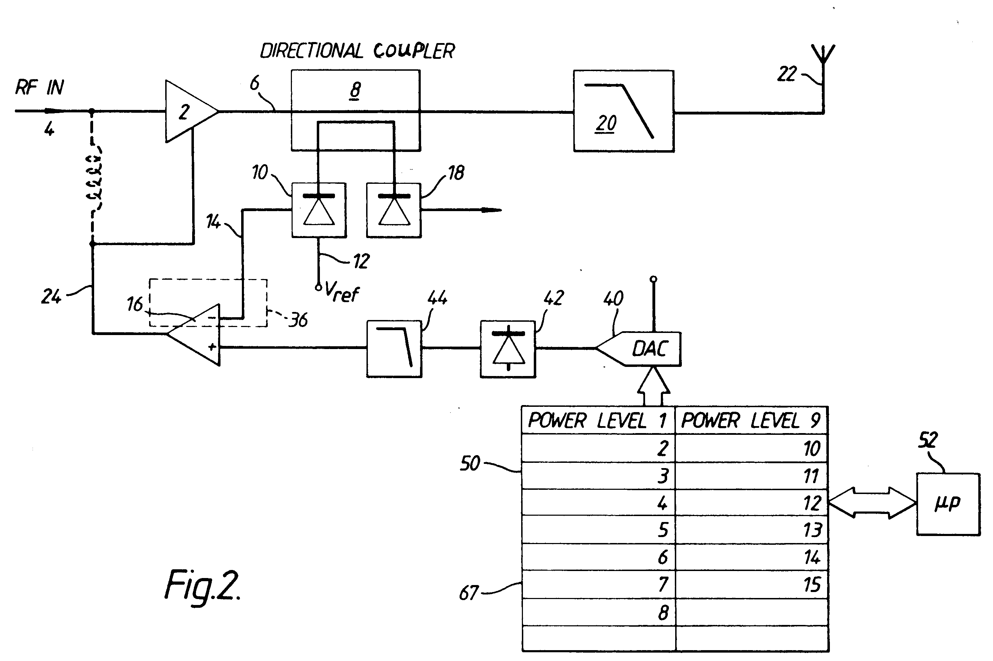

Figure 2 shows a control system for a power amplifier which may be implemented in a base station or in a mobile station of a radio telephone system. A transistor power amplifier 2 is coupled to receive an RF input signal (suitably GMSK modulated) on a line 4 and to provide an amplified version of the RF signal on a line 6. Typically the power levels on the output line are between 0.01 and 35 watts. A directional coupler 8 is provided comprising two parallel tracks on the printed circuit board so that RF energy is transferred to a diode detecting arrangement 10 wherein the voltage developed is compared with a reference voltage on line 12 in order to provide a control signal representing the energy of the power amplifier on line 14 to voltage comparator 16. A further power detection arrangement 18 is provided coupled to the other end of the directional coupler in order to detect reverse power being reflected from the antenna, indicating a mismatch situation, for example the antenna being disconnected. A low pass filter 20 is provided for removing harmonics in the output signal. Normally such a filter would be a diplexer arrangement, since the system shown will normally form part of a transceiver wherein received signals are at a different frequency from those transmitted. The output of filter 20 is connected to an antenna 22 which is of a conventional form, for example a λ/4 aerial projecting from a vehicle, or possibly an integral antenna in a receiver. As an alternative to a diplexer arrangement, a transmit/receive switch may be employed as a simplification.

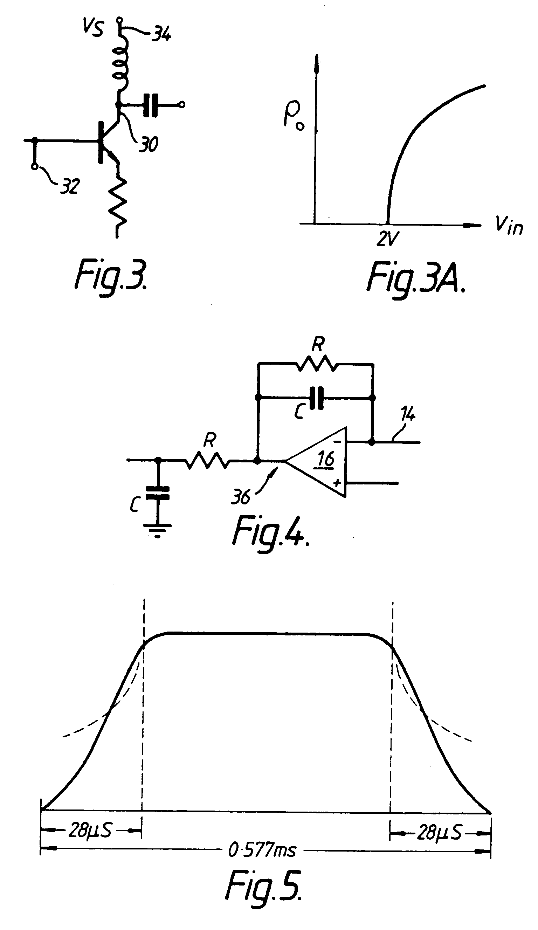

Voltage comparator 16 is connected via an output line 24 to power amplifier 2. As shown in Figure 3, power amplifier 2 includes a transistor 30 having a bias control input 32 at its base and a power supply control input 34 at its collector. Depending on the application, line 24 may be connected either to input 32 or input 34 (via suitable control circuitry). The power output characteristics for bias voltage applied to the base is shown in Figure 3a wherein power output remains zero until a threshold voltage of two volts is reached at which stage the power output increased very rapidly, then levelling off in a saturation-type region. Power amplifier 2 may operate in a class C or other mode, e.g. class AB.

Figure 4 indicates a phase control arrangement 36 for the control loop of Figure 2 wherein amplifier 16 has an RC feedback loop connected between its input and output, and a further RC stage coupled to its output. The effect of this filter arrangement is to ensure stability of the control loop without reducing the response speed.

The non-inverting input of comparator 16 is connected to a digital to analogue converter 40 via a diode arrangement 42 for compensating for temperature effects created within detecting arrangement 10. Diode arrangement 42 also compensates for non-linearities within diode detector 10. Diode arrangement 42 is coupled to a low pass filter 44 which is arranged to remove noise created in the digital to analogue conversion process. Converter 40 receives digital signal levels from a memory 50 which is controlled by a microprocessor arrangement 52.

In operation, when microprocessor arrangement 52 determines that the power amplifier should generate a pulse of RF energy, it will also determine the desired power level of the output energy and will supply appropriate memory read signals to memory 50. Memory 50 is arranged in the form shown in Figure 2 wherein different sections of memory are devoted to different power levels. Sixteen different power levels are provided in two decibel steps. Upon selecting say power level 7, the contents of section 67 are clocked out sequentially in order to provide a sequence of power level signals whose envelope is shown in Figure 5 wherein the power level increases within a time space of 28 ms from a zero level to a full power level by means of a raised cosine function. For the major part of the pulse, approximately 0.5 ms the power level remains constant, and at the end of the pulse the power level decreases within a time slot of 28 ms, again by means of a raised cosine function offset by a predetermined amount to a zero level. If desired, this function can be distorted as shown in dotted lines in Figure 5, to take account of the non-linearities in the power detection characteristics of the detector 10. The distortion of the data to take account of the non-linearity within the diode detector can be done by conventional arithmetic techniques.

There has thus been shown and disclosed a control system for a power amplifier for a radio telephone system which is suitable to meet the stringent requirements of the GSM system. It can cope with a wide range of changes in RF frequency and can provide a 30 decibel on/off power ratio.

Since the major part of the control function takes part outside the negative feedback loop, i.e. the removal of side band energy and the setting of power levels, the control loop can be arranged to act very quickly to adjust power output, and has a band width of about 0.2 to 0.3 MHz.

Features of the present invention include:-
1) Accurate control of the transmitter output power level.
2) Accurate control of the transmitter switching sidebands.
3) Accounts for non-linearities in the transmitter's detector circuitry.
4) Fast control of the transmitter power output level. 5) Reverse power detection for protection purposes.
6) Use with various types of transmitter control such as:
   a) Control via the supply to the first stage of the amplifer
   b) Control of the input bias to the first transistor stage in the transmitter.
7) Temperature compensation.
8) Detector linearisation.
9) A directional coupler providing a mismatch insensitivity on the transmitter output.

The method used includes a fast negative feedback control loop that is used for levelling. This then produces a controllable power output. To limit the switching sidebands, an external pulse is added to the control loop thus shaping the control pulse to the transmitter. The switching sidebands are thus controlled by the shape of the added pulse and by filtering outside the control loop.

With reference to US-A-4,523,155:-
1) The present invention employs voltage control to the transmitter as opposed to current control. This simplifies the control circuitry especially when control of the transmitter's input bias is used: the transmitter can be directly driven from the output of the comparator without the need for current drive circuitry.
2) The control loop of the invention has a much faster response time because the control loop includes only the comparator.
3) The transmitter control loop system of the present invention is superior because the noise sidebands are controllable due to the fact that the pulse shaping takes place outside the control loop and they are easily filtered.
4) The directional coupler provides detection of the amount of reverse power being reflected back from the antenna socket. This signal is then used to turn the transmitter off in dangerous circumstances.
5) An additional feature with using a directional coupler is that the transmitter is not sensitive to mismatched load impedances on its output. This thus eliminates the need for an isolator.
6) Temperature compensation is included in the added signal path. This then means that there are the same temperature characteristics both in the loop and outside so the two signals when added together have the same temperature characteristics and so are better matched.
7) The added advantage of including the temperature compensation outside the loop is that the diode included in the circuit is a Schottky diode that has similar RF and DC characteristics. This means that including a diode in both paths into the comparator serves to linearise the detector characteristics.
8) The external data bits entered into the digital to analogue converter determine the maximum transistor output level.

## Claims

1. A transmitter for a radio telephone system, comprising a power amplifier (2), detecting means (8,10) coupled to the output of the power amplifier (2) for detecting the output power of the amplifier (2) and producing an output power signal (14) dependent thereon, a voltage comparator (16) having a first input coupled to receive the output power signal (14) and a second input connected to receive a desired power signal dependent on the desired output power level for the power amplifier (2), the voltage comparator (16) being operative to produce an output control signal which is connected to control the output power level of the power amplifier (2) to the desired level, and control means (40,50,52) for producing the desired power level signal, the control means comprising memory means (50) having storage locations (e.g. 67) storing digital signals corresponding to different predetermined power levels, a control unit (52) operative in dependence on the desired one of the predetermined power levels to cause the corresponding stored digital signals to be read out of the memory means (50), and digital to analogue converting means (40) responsive to the read-out digital signals to produce the said desired power level signal, characterised by a phase adjustment circuit (36) coupled to the voltage comparator (16) and incorporating a negative feedback path (Fig. 4) for reducing undesirable phase shifts within the control loop, in that the desired power level signal is in the form of a desired power level signal pulse (Fig. 5) for causing the amplifier (2) to produce a corresponding pulse of output power, and in that the memory means (50) stores in each storage location (e.g. 67) digital data representing the value of a pulse corresponding to a respective one of the predetermined power levels, the read-out digital data being fed directly to the digital to analogue converter (40), initial and final portions of the digital data read-out being modified to cause the leading and trailing edges of the desired power level signal pulse to respectively increase and decrease progressively in a predetermined manner to reduce or eliminate RF sidebands created by the power amplifier (2).

2. A transmitter according to claim 1, characterised in that the desired output power level signal pulse of the voltage comparator (16) is applied as a control signal to the base of a power transistor (30) within the power amplifier (2).

3. A transmitter according to claim 1 or 2, characterised in that the detector means comprises a directional coupler arrangement (8) coupled to the output of the power amplifier (2) and connected to rectifier means (10) for producing the output power signal.

4. A transmitter according to any preceding claim, characterised in that the digital to analogue converter (40) is connected to the voltage comparator (16) via a diode arrangement (42) for compensating for temperature effects in the detector means (8,10).

5. A transmitter according to any preceding claim, characterised in that the initial and final data portions cause the leading and trailing edges of the desired output power signal pulse to increase and decrease according to a raised cosine function.

6. A transmitter according to any preceding claim, in which the initial and final data portions are further modified in a predetermined manner to take account of non-linearity in the detector means (10).

## Patentansprüche

1. Ein Transmitter für ein Funktelefonsystem, umfassend einen Leistungsverstärker (2), eine an den Ausgang des Leistungsverstärkers (2) gekoppelte Detektiereinrichtung (8, 10) zum Erfassen der Ausgangsleistung des Verstärkers (2) und zum Erzeugen eines davon abhängigen Ausgangsleistungssignals (14), einen Spannungskomparator (16) mit einem ersten Eingang, der so gekoppelt ist, daß er das Ausgangsleistungssignal (14) empfängt, und einem zweiten Eingang, der so angeschlossen ist, daß er ein erwünschtes Leistungssignal, das von dem erwünschten Ausgangsleistungspegel für den Leistungsverstärker (2) abhängt, empfängt, wobei der Spannungskomparator (16) operativ ist, um ein Ausgangssteuersignal zu erzeugen, das angeschlossen ist, um den Ausgangsleistungspegel des Leistungsverstärkers (2) auf den gewünschten Pegel zu steuern, und eine Steuereinrichtung (40, 50, 52) zum Erzeugen des erwünschten Leistungspegelsignals, wobei die Steuereinrichtung aufweist eine Speichereinrichtung (50) mit Speicherbereichen (beispielsweise 67) zum Speichern digitaler Signale, die den verschiedenen vorbestimmten Leistungspegeln entsprechen, eine Steuereinheit (52), die in Abhängigkeit von dem erwünschten der vorbestimmten Leistungspegel operativ ist, um zu bewirken, daß die entsprechenden gespeicherten digitalen Signale aus der Speichereinrichtung (50) ausgelesen werden, und eine Digital/Analog-Konvertereinrichtung (40), die auf die ausgelesenen digitalen Signale anspricht, um das erwünschte Leistungspegelsignal zu erzeugen, gekennzeichnet durch eine Phaseneinstellschaltung (36), die an den Spannungskomparator (16) gekoppelt ist und einen negativen Rückkopplungsweg (Fig. 4) umfaßt, um unerwünschte Phasenverschiebungen innerhalb der Steuerschleife zu reduzieren, dadurch daß das erwünschte Leistungspegelsignal in Form eines erwünschten Leistungspegelsignalimpulses (Fig. 5) vorliegt, um zu bewirken, daß der Verstärker (2) einen entsprechenden Ausgangsleistungsimpuls erzeugt, und dadurch daß die Speichereinrichtung (50) in jedem Speicherbereich (beispielsweise 67) digitale Daten speichert, die den Wert eines Impulses, der einem entsprechenden der vorbestimmten Leistungspegel entspricht, darstellen, wobei die ausgelesenen digitalen Daten direkt in den Digital/Analog-Konverter (40) eingespeist werden, Anfangs- und Endabschnitte der ausgelesenen digitalen Daten modifiziert werden, um zu bewirken, daß die Anstiegs- und Abfallflanke des erwünschten Leistungspegelsignalimpulses fortschreitend in einer vorbestimmten Weise ansteigt bzw. abfällt, um die durch den Leistungsverstärker (2) erzeugten RF-Seitenbänder zu reduzieren oder zu eliminieren.

2. Ein Transmitter nach Anspruch 1, dadurch gekennzeichnet, daß der erwünschte Ausgangsleistungspegelsignalimpuls des Spannungskomparators (16) als ein Steuersignal an die Basis eines Leistungstransistors (30) innerhalb des Leistungsverstärkers (2) angelegt wird.

3. Ein Transmitter nach Anspruch 1 oder 2, dadurch gekennzeichnet, daß die Detektoreinrichtung eine Richtkoppleranordnung (8) umfaßt, die an den Ausgang des Leistungsverstärkers (2) gekoppelt ist und an eine Gleichrichteinrichtung (10) angeschlossen ist, um das Ausgangsleistungssignal zu erzeugen.

4. Ein Transmitter nach einem der vorangegangenen Ansprüche, dadurch gekennzeichnet, daß der Digital/Analog-Konverter (40) über eine Diodenanordnung (42) an den Spannungskomparator (16) angeschlossen ist, um Temperatureffekte in der Detektoreinrichtung (8, 10) zu kompensieren.

5. Ein Transmitter nach einem der vorangegangenen Ansprüche, dadurch gekennzeichnet, daß die Anfangs- und Enddatenabschnitte bewirken, daß die Anstiegs- und Abfallflanke des erwünschten Ausgangsleistungssignalimpulses gemäß einer erhöhten Cosinusfunktion ansteigt und abfällt.

6. Ein Transmitter nach einem der vorangegangenen Ansprüche, in dem die Anfangs- und Enddatenabschnitte weiter in einer vorbestimmten Weise modifiziert werden, um eine Nichtlinearität in der Detektoreinrichtung (10) zu berücksichtigen.

## Revendications

1. Emetteur pour un système de radiotéléphonie, comprenant : un amplificateur de puissance (2) ; un moyen de détection (8, 10) connecté à la sortie de l'amplificateur de puissance (2) pour détecter la puissance de sortie de l'amplificateur (2) et pour produire un signal de puissance de sortie (14) qui en dépend ; un comparateur de tension (16) ayant une première entrée connectée de façon à recevoir le signal de puissance de sortie (14) et une seconde entrée connectée de façon à recevoir un signal de puissance voulue fonction du niveau de puissance de sortie voulu pour l'amplificateur de puissance (2), le comparateur de tension (16) servant à produire un signal de commande de sortie qui est appliqué de façon à commander le niveau de puissance de sortie de l'amplificateur de puissance (2) au niveau voulu ; et un moyen de commande (40, 50, 52) pour produire le signal de niveau de puissance voulu, le moyen de commande comprenant un moyen de mémorisation (50) comportant des positions de mémorisation (par exemple, 67) mémorisant des signaux numériques correspondant à niveaux de puissance prédéterminés différents ; un module de commande (52) servant, en fonction de l'un, voulu, des niveaux de puissance prédéterminés, à provoquer la lecture des signaux numériques mémorisés correspondants du moyen de mémorisation (50) ; et un moyen de conversion de numérique en analogique (40) sensible aux signaux numériques lus pour produire ledit signal de niveau de puissance voulue, caractérisé par un circuit de réglage de phase (36) relié au comparateur de tension (16) et incorporant un trajet de contre-réaction négative (figure 4) pour réduire les déphasages indésirables dans la boucle de commande ; en ce que le signal de niveau de puissance voulu a la forme d'une impulsion de signal de niveau de puissance voulu (figure 5) pour amener l'amplificateur (2) à produire une impulsion de sortie de puissance correspondante ; en ce que le moyen de mémorisation (50) mémorise dans chaque emplacement de mémorisation (par exemple, 67) une donnée numérique représentant la valeur d'une impulsion correspondant à l'un respectif des niveaux de puissance prédéterminés, la donnée numérique lue étant délivrée directement au convertisseur de numérique en analogique (40) , les parties initiale et finale de la donnée numérique lue étant modifiées pour faire en sorte que les fronts avant et arrière de l'impulsion de signal de niveau de puissance voulu augmentent et diminuent, respectivement, progressivement, d'une manière prédéterminée pour réduire ou éliminer les bandes latérales HF créées par l'amplificateur de puissance (2).

2. Emetteur selon la revendication 1, caractérisé en ce que l'impulsion de signal de niveau de puissance de sortie voulu du comparateur de tension (16) est appliquée, en tant que signal de commande, à la base d'un transistor de puissance (30) dans l'amplificateur de puissance (2).

3. Emetteur selon la revendication 1 ou 2, caractérisé en ce que le moyen détecteur comprend un agencement de coupleur directionnel (8) raccordé à la sortie de l'amplificateur de puissance (2) et connecté à un moyen redresseur (10) pour produire le signal de puissance de sortie.

4. Emetteur selon l'une quelconque des revendications précédentes, caractérisé en ce que le convertisseur de numérique en analogique (40) est connecté au comparateur de tension (16) par l'intermédiaire d'un agencement de diode (42) pour compenser les effets de la température dans le moyen détecteur (8, 10).

5. Emetteur selon l'une quelconque des revendications précédentes, caractérisé en ce que les parties de donnée initiale et finale provoquent l'augmentation et la diminution des fronts avant et arrière de l'impulsion de signal de puissance de sortie voulue suivant une fonction cosinus rehaussée.

6. Emetteur selon l'une quelconque des revendications précédentes, dans lequel les parties de donnée initiale et finale sont en outre modifiées d'une manière prédéterminée pour tenir compte de la non-linéarité dans le moyen détecteur (10).
